# EUROPÄISCHE PATENTANMELDUNG

(11) **EP 2 261 973 A2**
(43) Veröffentlichungstag der Anmeldung: **15.12.2010**
(21) Anmeldenummer: 10004377.7
(22) Anmeldetag: 24.04.2010
(51) Int. Cl.: H01L 25/07, H01L 25/16, H01L 23/10, H01L 23/498, H01L 23/34, H01L 23/049, H01L 23/00

(54) **Leistungselektronisches System**

(30) Priorität: 09.06.2009 DE 102009024369
(71) Anmelder: SEMIKRON Elektronik GmbH & Co. KG, 90431 Nürnberg (DE)
(72) Erfinder: Beckedahl, Peter, 90522 Oberasbach (DE); Knebel, Markus, 90587 Tuchenbach (DE); Stockmeier, Thomas, 91054 Erlangen (DE)

(57) **Zusammenfassung**

Die Erfindung beschreibt ein leistungselektronisches System mit einer Umhausung, einer Kühleinrichtung, einer Stromrichterschaltung, einem Kondensator sowie ersten und zweiten internen und externen Verbindungseinrichtungen, wobei die Stromrichterschaltung ein Substrat mit einer Mehrzahl hierauf angeordneter und mittels der ersten internen Verbindungseinrichtung schaltungsgerecht verbundener Leistungshalbleiterbauelemente aufweist. Die erste interne Verbindungseinrichtung ist mit zugeordneten Anschlusselementen der Kondensatoren und zweiten internen Verbindungseinrichtungen verbunden. Die Umhausung umschließt zusammen mit der Kühleinrichtung die Stromrichterschaltung, die Kondensatoren und die internen Verbindungseinrichtungen, wobei der hierbei entstandene Innenraum mittels eines Isolierstoffes gefüllt ist. Weiterhin sind die Öffnungen an denen die ersten und zweiten Verbindungseinrichtungen die Umhausung oder die Kühleinrichtung durchdringen gegen Umwelteinflüsse abgedichtet.

## Beschreibung

Die Erfindung beschreibt ein leistungselektronisches System mit einer Umhausung, einer Kühleinrichtung, einer Stromrichterschaltung, mindestens einem Kondensator sowie ersten und zweiten internen und externen Verbindungseinrichtungen, wie es bevorzugt in teilweise oder vollständig elektrisch betriebenen Fahrzeugen Verwendung findet.

Aus der DE 101 27 947 A1 ist grundsätzlich ein Leistungshalbleitermodul bekannt mit einem Grundkörper, einem Substrat mit Bauelementen mit komplex ausgestalteten Lastanschlusselementen und mindestens einem Kondensator, wobei die Zwischenkreisplatine Kontaktelemente zur direkten niederinduktiven Kontaktierung mit zugehörigen Leiterbahnen aufweist. Weiterhin ist vorgesehen die Zwischenkreisplatine zur Anordnung der Kondensatoren zu verwenden.

Nachteilig an einer derartigen Ausgestaltungen ist allerdings, dass hierbei eine Vielzahl von Einzelkomponenten zu einem derartigen leistungselektronischen System zusammengefügt werden müssen was mit einem entsprechend aufwändigen Herstellungsprozess einher geht.

Der vorliegenden Erfindung liegt die Aufgabe zu Grunde ein leistungselektronisches System vorzustellen, das einer einfachen Herstellung zugänglich ist, hierzu wenige Einzelkomponenten aufweist und gleichzeitig kompakt ausgestaltet ist und einen Schutz der Stromrichterschaltung vor Umwelteinflüssen gewährleistet.

Diese Aufgabe wird gelöst durch ein leistungselektronisches System gemäß Anspruch 1, wobei spezielle Ausgestaltungen in den jeweiligen abhängigen Ansprüchen genannt sind.

Die Grundlage des erfindungsgemäßen leistungselektronischen Systems mit einer Umhausung, einer Kühleinrichtung, mindestens einem Kondensator sowie internen und externen Verbindungseinrichtungen bildet eine grundsätzlich bekannte Stromrichterschaltung. Diese ist vorzugsweise folgendermaßen ausgebildet. Auf einem isolierenden Substrat ist eine Mehrzahl von Leitbahnen ausgebildet, die ihrerseits Leistungshalbleiterbauelement und auch mindestens ein Sensorbauelement tragen. Die Leiterbahnen des Substrats bilden somit einen Teil der schaltungsgerechten Verbindungen dieser Bauelemente, den anderen Teil bildet eine erste interne Verbindungseinrichtung.

Diese Verbindungseinrichtung ist ihrerseits vorteilhafterweise ausgebildet als eine Schichtfolge mit einer ersten elektrisch leitenden strukturierten Metallfolie, einer elektrisch isolierenden Folie und einer zweiten elektrisch leitenden strukturierten Metallfolie. Hierbei bilden die jeweiligen Strukturierungen erste und zweite Leiterbahnen aus den jeweiligen Metallfolien, die ihrerseits die oben genannten schaltungsgerechten Verbindungen ausbilden. Selbstverständlich ist auch die Anordnung einer weiteren Schichtfolge mit jeweils einer weiteren isolierenden und einer weiteren elektrisch leitenden Folie als gemeinsame erste interne Verbindungseinrichtung hier subsumiert.

Erfindungsgemäß weist das leistungselektronische System noch eine zweite interne Verbindungseinrichtung auf, die vorzugsweise ausgebildet ist als mindestens ein flächiger Metallformkörper, vergleichbar der externen Verschienung von bekannten Leistungshalbleitermodulen.

Diese zweite interne Verbindungseinrichtung verbindet den mindestens einen Kondensator mit der ersten Verbindungseinrichtung und hierüber mit den Leistungshalbleiterbauelementen. Hierzu weist der mindestens eine Kondensator Anschlusselemente auf, die vorzugsweise stoffschlüssig mittels einer Schweißverbindung mit der zweiten Verbindungseinrichtung verbunden ist.

Weiterhin weist das leistungselektronische System eine Kühleinrichtung mit einer ersten Hauptfläche zur Anordnung der Stromrichterschaltung und eine Mehrzahl von Kühlmitteln auf, die vornehmlich dem Wärmeübergang auf ein Kühlmedium dienen. Die Stromrichterschaltung ist hierbei bevorzugt mittels einer Niedertemperatursinterverbindung stoffschlüssig mit der Kühleinrichtung verbunden, um einen effizienten Wärmeübergang von den Leistungshalbleiterbauelementen über das Substrat auf die Kühleinrichtung zu gewährleisten.

Die Kühleinrichtung bildet zusammen mit einer Umhausung einen Innenraum, in dem die Stromrichterschaltung, der mindestens einen Kondensator sowie die internen Verbindungseinrichtungen angeordnet sind. Dieser so entstandene Innenraum ist mittels eines Isolierstoffes zumindest annähernd vollständig gefüllt. Hierbei umschließt der Isolierstoff nicht nur die Stromrichterschaltung und dient deren elektrischer Isolierung, sondern umschließt auch den mindestens einen Kondensator und die internen Verbindungseinrichtungen. Als Isolierstoff hat sich hierbei ein mit keramischen Pulver gefülltes Silikongel als besonders geeignet erwiesen, da hierdurch nicht nur die elektrische Isolierung gewährleistet wird sondern auch die Wärmeabfuhr aus den Wärmequellen verbessert wird. Um ein Austreten des Isolierstoffes zu verhindern ist zwischen der ersten Hauptfläche der Kühleinrichtung und der Umhausung eine erste Dichteinrichtung vorgesehen.

Hierbei ist die Umhausung vorzugsweise als ein Metallgehäuse ausgebildet. Alternativ wird diese Umhausung durch die Außenfläche des Isolierstoffes selbst gebildet. Hierbei findet als Isolierstoff vorteilhafterweise eine Epoxydharzverbindung Einsatz. Durch eine derartige einstückige Ausgestaltung des Isolierstoffes und der Umhausung kann die Stromrichterschaltung, die internen Verbindungseinrichtungen und der mindestens eine Kondensator in einem Arbeitsgang elektrisch gegeneinander isoliert werden und gleichzeitig vor Umwelteinflüssen geschützt werden.

Zur externen elektrischen Verbindung sind erste und zweite externe Verbindungseinrichtungen vorgesehen, die an Öffnungen der Umhausung oder eines geeigneten Teils der Kühleinrichtung mit den zugeordneten ersten und zweiten internen Verbindungseinrichtung ein- oder mehrstückig verbunden sind. Diese Öffnungen sind dabei derart gestaltet, dass die Verbindungseinrichtungen hier elektrisch gegen die Umhausung, falls notwenig, oder gegen die Kühleinrichtung isoliert sind.

Vorzugsweise bildet die erste externe Verbindungseinrichtung die externen Anschlüsse mit Hilfspotential aus, während die zweite externe Verbindungseinrichtung die Anschlüsse mit Lastpotential ausbildet.

Weiterhin kann es bevorzugt sein, wenn die Umhausung als Metallgehäuse mit einen zusätzlichen Hohlraum als Teil des Innenraums ausgebildet ist. Die Öffnung dieses Hohlraums zum Innenraum ist hierbei auf derjenigen Seite des Hohlraums angeordnet ist, der einer Befüllöffnung zur Befüllung des Innenraums mit dem Isolierstoff abgewandt ist. Diese Befüllöffnung kann gleichzeitig eine der Öffnungen zur Durchführung der Verbindungseinrichtungen sein. Durch die Lage der Öffnung des Hohlraums wird dieser bei der Befüllung mit dem Isolierstoff nicht vollständig gefüllt, wodurch sich der Isolierstoff bei thermischer Ausdehnung im Betrieb in diesen Hohlraum hinein ausdehnen kann.

Die Erfindung wird anhand von Ausführungsbeispielen in Verbindung mit den Fig. 1 bis 3 näher erläutert.

Fig. 1 zeigt ein erfindungsgemäßes leistungselektronisches System in Schnittdarstellung.

Fig. 2 zeigt eine Abwandlung des leistungselektronischen Systems gemäß Fig. 1.

Fig. 3 zeigt ein erfindungsgemäßes leistungselektronisches System in dreidimensionaler Darstellung.

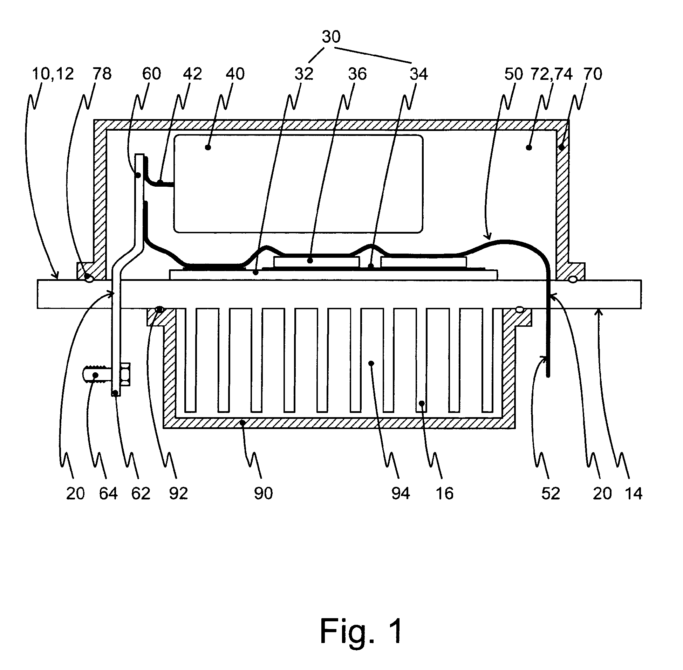

Fig. 1 zeigt ein erfindungsgemäßes leistungselektronisches System in Schnittdarstellung, welches eine Stromrichterschaltung (30) in Form eines Dreiphasen-Wechselrichter mit Zwischenkreiskondensator (40), Verbindungseinrichtungen (50, 60) und Kühleinrichtung (10) umfasst. Die Kühleinrichtung (10) weist hierbei eine erste Hauptfläche (12) zur Anordnung der Stromrichterschaltung (30) und auf ihrer dieser Hauptfläche (12) abgewandten Seite eine Mehrzahl von Kühlmitteln (16) auf. Diese Kühlmittel (16) sind hier in Richtung der Zeichenebene von einem flüssigen Kühlmedium (94) durchflossen. Hierzu weist die Kühleinrichtung (10) einen Medienkanal (90) auf, der entweder einstückig mit der Kühleinrichtung (10), oder wie hier dargestellt zweistückig mit einer zweiten Dichteinrichtung (92) zur zweiten Hauptfläche (14) der Kühleinrichtung (10) ausgebildet ist.

Weiterhin weist die Kühleinrichtung (10), selbstverständlich außerhalb des Medienkanals (90) angeordnet, eine Mehrzahl von Öffnungen (20) auf. Durch diese Öffnungen (20) reicht erste (50, 52) und zweite (60, 62) Verbindungseinrichtungen hindurch. Diese Verbindungseinrichtungen teilen sich in interne (50, 60) und externe (52, 62) Verbindungseinrichtungen. Die externen (52, 62) dienen der elektrischen Verbindung des leistungselektronischen Systems innerhalb eines größeren Verbundes, beispielhaft einem Elektrofahrzeug.

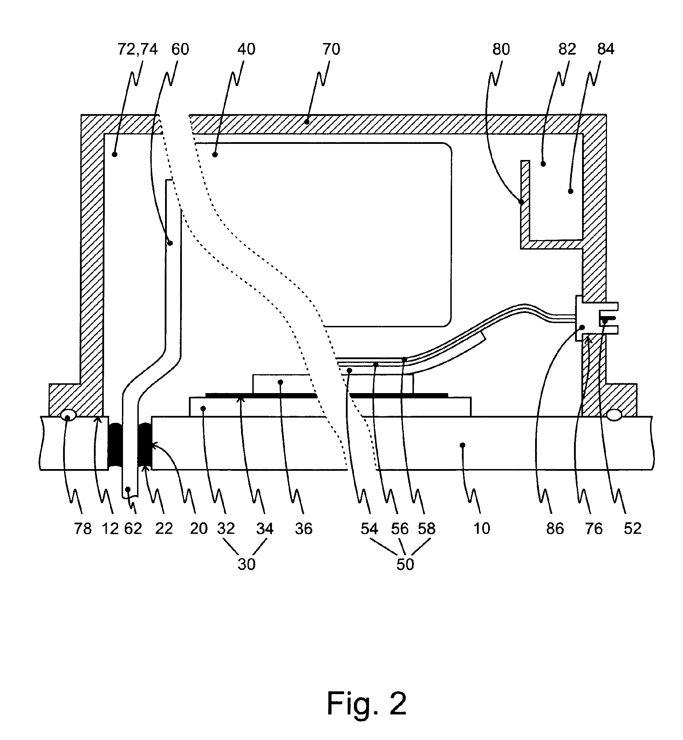

Die internen Verbindungseinrichtungen (50, 60) verbinden die Stromrichterschaltung (30), die auf der ersten Hauptfläche (12) der Kühleinrichtung (10) angeordnet ist, mit direkt benachbart zu dieser Stromrichterschaltung (30) angeordneten Kondensatoren (40). Diese Stromrichterschaltung (30) weist zur Verbindung ihrer Komponenten (36), wie Leistungshalbleiterbauelemente, eine erste Verbindungseinrichtung (50) auf, die ausgebildet ist als die oben genannte Schichtfolge mit einer ersten elektrisch leitenden und strukturierten Metallfolie (vgl. Fig. 2, 54), einer elektrisch isolierenden Folie (vgl. Fig. 2, 56) und einer zweiten elektrisch leitenden und strukturierten Folie (vgl. Fig. 2, 58). Die jeweiligen Strukturierungen der Metallfolien bilden somit die Leiterbahnen für Last- und Hilfspotentiale aus.

Weiterhin dient die erste interne Verbindungseinrichtung (50), die an einer Öffnung (20) der Kühleinrichtung (10) einstückig in die erste externe Verbindungseinrichtung (52) übergeht dazu Hilfspotentiale nach außen zu führen und somit der Steuerung der Leistungshalbleiterbauelement (36) der Stromrichterschaltung (30).

Anderseits ist die erste interne Verbindungseinrichtung (50) mit einer zweiten internen Verbindungseinrichtung (60), die hier als eine Mehrzahl flächiger Metallformkörper, meist als Kupferflachleiter, ausgebildet ist, verbunden. Diese zweite interne Verbindungseinrichtung (60) ist weiterhin mit den Anschlusselementen (42) der Kondensatoren (40) verbunden. Es kann auch bevorzugt sein die erste und zweite interne Verbindungseinrichtung (50, 60) gleichartig auszubilden, allerdings bildet die hier dargestellte Variante die sinnvollste Ausgestaltung. Es wird einerseits die Flexibilität der Ausgestaltung als Schichtfolge von Folien zur Verbindung der Stromrichterschaltung (30) und anderseits die mechanische Stabilität der Kupferflachleiter an jeweils geeigneter Stelle genutzt.

Die Kondensatoren (40), die internen Verbindungseinrichtungen (50, 60) und die Stromrichterschaltung (30) werden umschlossen von der ersten Hauptfläche (12) der Kühleinrichtung (10) und einem Umhausung (70), die hier als Metallgehäuse ausgebildet und über erste Dichtmittel (78) mit der Kühleinrichtung (10) verbunden ist. Somit ist der Innenraum mit Ausnahme der Öffnungen (20) für die Durchführung der Verbindungseinrichtungen abgeschlossen. Diese Durchführungen (20) können gleichzeitig als Befüllöffnung zur Befüllung des Innenraums dienen, da eine elektrische Isolierung der Verbindungseinrichtung gegen die Kühleinrichtung (10) notwendig ist und diese erst nach der Befüllung des Innenraums (72) angeordnet werden kann.

Durch die geeignete Befüllung des Innenraums (72) mit einem Isolierstoff (74) kann auf eine eigene Isolierung der Kondensatoren (40) zumindest teilweise verzichtet werden. Gleichfalls können auch Standardkondensatoren Verwendung finden.

Es ist selbstverständlich bevorzugt, wenn das nicht von der Stromrichterschaltung (30), den internen Verbindungseinrichtungen (50, 60) und den Kondensatoren (40) beanspruchte Volumen des Innenraums (72) möglichst klein ist um die notwendig Menge des Isolierstoffs (74) zu begrenzen. Eine zu große Menge bedeutet einerseits eine unnötige Masse und anderseits müssen möglicherweise Maßnahmen gegen Wärmeausdehnung des Isolierstoffs (74) getroffen werden.

Fig. 2 zeigt eine Abwandlung des leistungselektronischen Systems gemäß Fig. 1 in Teilansicht. Dargestellt sind wiederum eine Umhausung (70) in Gestalt eines Metallgehäuses sowie die erste Verbindungseinrichtung, die hier aus einer ersten internen Verbindungseinrichtung (50) und einer ersten externen Verbindungseinrichtung (52) besteht, wobei die erste interne Verbindungseinrichtung die oben beschriebene Schichtfolge ist. Die Durchführung erfolgt hier nicht durch die Kühleinrichtung, sondern durch eine Öffnung (76) im Metallgehäuse (70). In dieser Öffnung (76) ist ein Steckverbinder (86) angeordnet, dessen äußerer Steckkontakt die erste externe Verbindungseinrichtung (52) ausbildet. Vorzugsweise ist dieser Steckverbinder (86) mehrpolig ausgebildet um eine Mehrzahl verschiedener Hilfspotentiale zu führen.

Weiterhin dargestellt ist ein Hohlraum (84) als Teil des Innenraums (72), der einstückig mittels einer geeigneten Ausformung (80) mit dem Metallgehäuse (70) ausgebildet ist. Es kann auch vorteilhaft sein diesen Hohlraum (84) anderweitig, beispielhaft als Teil der zweiten internen Verbindungseinrichtung (60) auszubilden. Der Hohlraum (84) selbst weist eine Öffnung (82) auf, wobei diese auf derjenigen Seite des Hohlraums (84) angeordnet ist, der einer Befüllöffung zur Befüllung des Innenraums (72) mit dem Isolierstoff (74) abgewandt ist. Somit wird bei Befüllung des Innenraums (72) mit dem Isolierstoff (74) der Hohlraum (84) nicht vollständig befüllt, da sich hierin eine Luftblase bildet. Im Betrieb des leistungselektronischen Systems sind die Befüllöffnung und auch alle anderen Öffnungen (20, 76) verschlossen wodurch dieser Hohlraum (84) als Ausdehnungsbereich für den Isolierstoff (74) bei dessen thermischer Ausdehnung dient.

Ebenso dargestellt ist eine Öffnungen (20) der Kühleinrichtung (10) zur Durchführung einer zweiten Verbindungseinrichtung (60, 62). Diese Öffnung (20) wurde nach der Befüllung des Innenraums (72) mit dem Isolierstoff (74) mit einer dauerelastischen hermetisch dichtenden Dichtmasse (22) verschlossen. Somit ist das leistungselektronische System auch für den Einsatz in rauen Umgebungsbedingungen, wie sie beispielhaft im Motorraum eines Fahrzeugs herrschen hervorragend geeignet. Zudem weist die Ausgestaltung den vorteilhaft einer kompakten, stabilen Systemkomponente auf, die nur noch mit einer Batterie, einem Motor und einer Steuerung und einer Versorgung mit Kühlmedium verbunden werden muss, um eine elektrische Antriebsgruppe auszubilden.

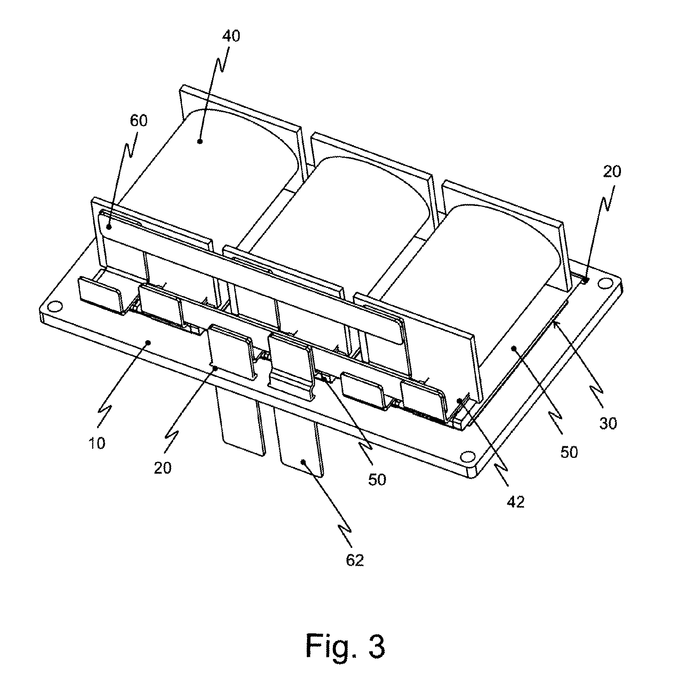

Fig. 3 zeigt ein erfindungsgemäßes leistungselektronisches System in dreidimensionaler Darstellung, mit den oben beschriebenen Einzelteilen, wie Kühleinrichtung (10), Substrat (30), ersten (50) und zweiten (60, 62) Verbindungseinrichtungen und Kondensatoren (40). Gegenüber den bisherigen Ausführungsbeispielen unterscheide sich dieses dadurch, dass hier kein Metallgehäuse als Umhausung vorgesehen ist.

Zur Ausgestaltung mit einer besonders geringen Anzahl von Einzelkomponenten, die zueinander angeordnet werden müssen, wird hier der Schutz vor Umwelteinflüssen und gleichzeitig die notwendige interne Isolierung durch eine einstückige Ausbildung der Umhausung und des Isolierstoffes erreicht. Hierzu wird der gesamte Bereich oberhalb der ersten Hauptfläche in einem Verguss- oder Tauchverfahren mit einem Epoxydharz versehen, das einerseits die Funktion des Isolierstoffs und andererseits diejenigen der Umhausung erfüllt. Hierbei ist es bevorzugt, aber nicht notwendig, wenn die ersten Verbindungseinrichtungen (50, 52) durch Öffnungen (20) der Kühleinrichtung (10) nach Außen geführt sind.

## Patentansprüche

1. Leistungselektronisches System mit einer Umhausung (70), einer Kühleinrichtung (10), einer Stromrichterschaltung (30), mindestens einem Kondensator (40) sowie ersten (50, 52) und zweiten (60, 62) internen und externen Verbindungseinrichtungen wobei die Stromrichterschaltung (30) ein Substrat (32) mit einer Mehrzahl hierauf angeordneter und mittels der ersten internen Verbindungseinrichtung (50) schaltungsgerecht verbundener Leistungshalbleiterbauelemente (36) aufweist und mit ihrem Substrat (32) auf einer ersten Hauptfläche (12) der Kühleinrichtung (10) angeordnet ist,
die erste interne Verbindungseinrichtung (50) mit zugeordneten Anschlusselementen (42) der Kondensatoren (40) und zweiten internen Verbindungseinrichtungen (60) verbunden ist,
die Umhausung (70) zusammen mit der Kühleinrichtung (10) die Stromrichterschaltung (30), die Kondensatoren (40) und die internen Verbindungseinrichtungen (50, 60) umschließt und der hierbei entstandene Innenraum (72) mittels eines Isolierstoffes (74) zumindest annähernd vollständig gefüllt ist
wobei die ersten (50, 52) und zweiten (60, 62) Verbindungseinrichtungen die Umhausung (70) oder die Kühleinrichtung (10) an zugeordneten Öffnungen (20, 76) durchdringen und diese Öffnungen (20, 76) gegen Umwelteinflüsse abgedichtet sind.

2. Leistungselektronisches System nach Anspruch 1, wobei
die erste interne Verbindungseinrichtung (50) ausgebildet ist als eine Schichtfolge mit einer ersten elektrisch leitenden und strukturierten Metallfolie (54), einer elektrisch isolierenden Folie (56) und einer zweiten elektrisch leitenden und strukturierten Folie (58), wobei die jeweiligen Strukturierungen der jeweiligen Metallfolien Leiterbahnen für Last- und Hilfspotentiale ausbilden.

3. Leistungselektronisches System nach Anspruch 2, wobei
die erste interne Verbindungseinrichtung (50) nach Durchführung durch die Umhausung (70) oder die Kühleinrichtung (10) die erste externe Verbindungseinrichtung (52) für Hilfspotentiale ausbildet.

4. Leistungselektronisches System nach Anspruch 2, wobei
die erste interne Verbindungseinrichtung (50) mit der ersten externe Verbindungseinrichtung (52) mittels eines in der Umhausung (70) oder der Kühleinrichtung (10) angeordneten Steckverbinder (86) verbunden ist.

5. Leistungselektronisches System nach Anspruch 1, wobei
die zweite interne Verbindungseinrichtung (60) ausgebildet ist als mindestens ein flächiger Metallformkörper, der Abschnitte aufweist, die durch die Umhausung oder den Kühlkörper hindurchreichen und dort die zweite externe Verbindungseinrichtung (62) für Lastpotentiale ausbildet.

6. Leistungselektronisches System nach Anspruch 1, wobei
das Substrat (30) mit der Kühleinrichtung (10) stoffschlüssig mittels einer Niedertemperatursinterverbindung verbunden ist.

7. Leistungselektronisches System nach Anspruch 1, wobei
die Anschlusselemente (42) der Kondensatoren (40) mit der zweiten internen Verbindungseinrichtung (60) mittels stoffschlüssig mittels eine Schweißverbindung verbunden ist.

8. Leistungselektronisches System nach Anspruch 1, wobei
die Umhausung (70) durch den Isolierstoff (74) selbst oder durch ein Metallgehäuse mit einer ersten Dichteinrichtung (78) zur ersten Hauptfläche (12) der Kühleinrichtung (10) ausgebildet wird.

9. Leistungselektronisches System nach Anspruch 8, wobei
das Metallgehäuse (70) einen Hohlraum (84) als Teil des Innenraums (72) mit einer Öffnung (82) aufweist, wobei diese auf derjenigen Seite des Hohlraums (84) angeordnet ist, der einer Befüllöffnung zur Befüllung des Innenraums (72) mit dem Isolierstoff (74) abgewandt ist und dieser Hohlraum (84) nicht vollständig mit dem Isolierstoff (74) gefüllt ist.
